# EUROPEAN PATENT APPLICATION

(11) **EP 4 276 919 A1**
(43) Date of publication of application: **15.11.2023**
(21) Application number: 23172485.7
(22) Date of filing: 10.05.2023
(51) Int. Cl.: H01L 31/18, H01L 31/073

(54) **METHOD FOR MANUFACTURING A SEMI-FINISHED CDTE BASED THIN FILM SOLAR CELL DEVICE**

(30) Priority: 10.05.2022 CN 202210509346
(71) Applicant: China Triumph International Engineering Co., Ltd., Shanghai 200063 (CN); CTF Solar GmbH, 01099 Dresden (DE)
(72) Inventor: Peng, Shou, Shanghai (CN); Ma, Liyun, Shanghai (CN); Yin, Xinjian, Shanghai (CN); Fu, Ganhua, Shanghai (CN); Späth, Bettina, Dresden (DE)
(74) Representative: Kailuweit & Uhlemann Patentanwälte Partnerschaft mbB

(57) **Abstract**

The invention concerns a method for manufacturing a semi-finished CdTe based thin film solar cell device at least comprising the following steps: a) providing a substrate, b) forming a CdTe based absorber layer, c) performing an activation treatment, and d) performing a flashlight treatment, wherein the flashlight treatment in step d) is performed before, after and/or during the activation treatment in step c).

## Description

The invention concerns a method for manufacturing a semi-finished CdTe based thin film solar cell device.

### State of the art

In the state of the art, CdTe based thin film solar cell devices are produced in superstrate configuration with the following process sequence: on a usually transparent substrate, like a glass substrate a first electrode layer is deposited as a front contact. On this, a layer of cadmium sulfide (CdS) may be deposited, followed by a CdTe based absorber layer. The CdTe based absorber layer is then activated with an activating agent, e.g. CdClz, and a temperature treatment step. Finally a second electrode layer, e.g. metal layer or a metal compound layer is applied as a back contact to collect the charge carriers. Also CdTe based thin film solar cell devices in substrate configuration are known from state of the art.

The CdTe based absorber layer may be deposited by a variety of different methods known from state of the art, like physical vapour deposition (PVD), electrochemical deposition and so on.

The activation treatment of the CdTe based absorber layer is a crucial step in manufacturing CdTe based thin film solar cell devices enabling for example intermixing of different absorber layer materials, doping of the absorber layer as well as reducing defect density within the absorber layer. New methods of production CdTe based thin film solar cell devices are constantly being investigated to improve photovoltaic efficiency.

For example CN 103 173 829 A discloses a method for preparing CdTe semiconductor films by electrochemical deposition under irradiation with a light source, like a xenon lamp, mercury xenon lamp, metal halide lamp etc. to improve the preparation efficiency resulting in thicker CdTe films in the same deposition time and improved crystallinity of the CdTe semiconductor films.

Other developments try to improve the composition of the absorber layer by incorporating doping elements at predetermined places within the absorber layer or by changing the stoichiometry of the absorber layer over its thickness by forming Cd, Se or Te rich portions. For example, US 2011 0143493 A1, US 10,529,883 B2 and US 2011 0117696 A1 show different approaches. US 2011 0143493 A1 describes different methods for obtaining enhanced p-type doping levels within a photo-active CdTe material. US 10,529,883 B2 discloses forming a CdSeₓTe₁₋ₓ compound absorber layer with a defined amount and distribution of the Se over the thickness of the absorber layer. US 2011 0117696 A1 describes methods for forming a Te-rich surface of a CdTe absorber layer.

### Object of the invention

Object of the invention is therefore to provide an alternative method for manufacturing a semi-finished CdTe based thin film solar cell device with improved photovoltaic efficiency.

### Solution

The object is solved by a method according to the independent claim. Preferred embodiments are given in the dependent claims.

The Method according to the invention for manufacturing a semi-finished CdTe based thin film solar cell device comprises at least the following steps:
a) Providing a substrate,
b) Forming a CdTe based absorber layer,
c) Performing an activation treatment,
d) Performing a flashlight treatment,
wherein the flashlight treatment in step d) is performed before, after and/or during the activation treatment in step c).

According to the invention, a substrate means any basis on which the CdTe based absorber layer is formed in step b). That is, the substrate may comprise a transparent base substrate, for instance of glass, a transparent front electrode and further layers like buffer layers, window layers or any else. In other embodiments, the substrate may comprise a transparent or opaque back electrode and further layers like buffer layers or any else. That is, the substrate may be glass, polymeric, metallic, or ceramic material or any other material.

A CdTe based absorber layer means an absorber layer like CdTe, CdSeₓTe₁₋ₓ , CdₓZn₁₋ₓTe, CdₓMn₁₋ₓTe, CdₓMg₁₋ₓTe, in each case undoped or doped with suitable doping materials. The CdTe based absorber layer may be formed onto the provided substrate with the aforementioned layers on top using any technique known from the prior art, comprising, but not limited to, physical vapour deposition, e.g. sputtering, evaporation or sublimation, electrodeposition, or any else. The absorber layer may be deposited layer by layer, e.g. subsequently depositing one or a plurality of layers of for instance CdSe and CdTe or of doping layers, followed by interdiffusion of the different layers if desired, or in one undivided process. Furthermore, processes for changing the composition of the surface portion of the absorber layer may be performed, for instance an NP etch (phosphorus nitride etch) for forming a Te-rich surface portion. In further embodiments, the absorber layer is formed with a thickness from 1 µm to 5 µm, preferably with a thickness from 2 µm to 3 µm.

The activation treatment of the present invention induces recrystallization, reduces lattice defects and improves the pn junction or its formation and is usually performed after formation of the CdTe based absorber layer. Furthermore, this step may improve intermixing of different compounds and/or elements resulting in forming of mixed or doped compounds. The activation treatment may comprise a thermal treatment and/or a treatment with a chemical activation agent. The activation treatment is known from the state of the art, wherein, however, parameters of the activation treatment according to the invention may differ from that of the prior art. Such parameters are, for instance, temperature, time or duration, the kind or the amount of the chemical activation agent or the composition and pressure of a surrounding atmosphere.

According to the invention, a flashlight treatment is performed before, after and/or during the activation treatment. In further embodiments, the flashlight treatment is performed after forming the CdTe based absorber layer in step b). Due to the flashlight treatment, the temperature within the CdTe based absorber layer increases for a very short time to very high temperatures, enabling diffusion of atoms, molecules, molecules clusters or charged particles like ions, charge carriers and/or doping species within the CdTe based absorber layer. Relaxation processes initiated thereby improve the absorber layer quality by reducing existing energy traps and recombination centres and therefore improve photovoltaic efficiencies of a solar cell device made of the semi-finished CdTe based thin film solar cell device. The flashlight treatment may also influence the doping concentration and/or distribution within the CdTe based absorber layer as well as intermixing of different layers the CdTe based absorber layer is formed from in certain embodiments. Furthermore advantageously, the flashlight treatment may influence following process steps for completing the semi-finished CdTe based thin film solar cell device to a CdTe based thin film solar cell device, preferably the activation treatment, so that time, temperature and/or amount of chemical activation agent of the activation treatment may be reduced. Furthermore, the flashlight treatment may change the internal electric field within the CdTe based absorber layer due to generation of charge carriers. The flashlight treatment causes an additional internal electric field within the absorber layer, wherein this additional internal electric field provides a drift potential to charged particles and therefore causes a controlled diffusion of these charged particles within the absorber layer. The additional internal electric field is additional since it is additional to an internal electric field caused by a pn-junction within the absorber layer. The diffusion of the charged particles is controlled by the strength and duration of the additional internal electric field.

Although the invention concerns the treatment of the absorber layer with flashlight in particular, it should be noted that any electromagnetic radiation causing an additional internal electric field within the absorber layer may be used for the treatment. Furthermore, the light treatment may be supported by an external electro-magnetic field provided, for instance, by plate capacitor, wherein the absorber layer is arranged between the plates of it, or by applying a voltage on at least one side of the absorber layer. In some cases, the light treatment may even be replaced by providing an external electro-magnetic field.

In embodiments, a method for manufacturing a semiconductor based thin film device comprises at least the following steps: a) providing a substrate, b) forming a semiconductor layer, c) performing an activation treatment, and d) performing a flashlight treatment, wherein the flashlight treatment in step d) is performed before, after and/or during the activation treatment in step c). Advantageously, this method improves the quality of the semiconductor layer not sensitive to degradation by light irradiation.

In embodiments, the flashlight treatment is performed as a single or multiple flashlight treatment.

A single flashlight treatment comprises one pulse of flashlight. A multiple flashlight treatment comprises more than one pulse of flashlight. In further embodiments, a multiple flashlight treatment comprises 2 to 1×10⁹ pulses, preferably for the entire duration of the activation treatment if performed concurrently with the activation step.

In embodiments, the flashlight treatment is performed with pulse durations in the range of 1 microsecond to 20 ms, for instance in the range of 0.3 ms to 20 ms. The break between multiple flashlight pulses can vary from 10 microseconds to 30 min. In some embodiments, the flashlight treatment can therefore be performed twice, once at the beginning and once at the end of the activation treatment. Advantageously, the flashlight treatment is a very fast treatment easy to include in manufacturing processes.

In embodiments, the flashlight treatment is performed with pulse energies in the range of 0.1 mJ/cm² to 60 J/cm², for instance in the range of 2 J/cm² to 30 J/cm². Advantageously, temperatures high enough to enable diffusion, intermixing and relaxation processes will be achieved within the CdTe based absorber layer.

In embodiments, the flashlight treatment is performed with wavelengths in the range for 250 nm to 1000 nm. The light may comprise a full spectrum of wavelengths in the mentioned ranges, i.e. from UV to IR (infrared), or may comprise only some specific wavelengths or subranges in the mentioned ranges. If specific wavelengths or subranges are used, they may be used simultaneously or consecutively.

In embodiments, the flashlight is provided by any known flashlight source, e.g. flashtubes meaning sealed glass tubes filled with a noble gas like for instance xenon.

In embodiments, the semi-finished CdTe based thin film solar cell device is additionally heated during the flashlight treatment in step d). This is advantageous if the flashlight treatment is performed before or after the activation treatment. Advantageously, in some cases, the activation temperature may thus also be kept at lower levels than without flashlight treatment. Another advantage of the flashlight treatment refers to the speed of the temperature and heating transition. The temperature rises rapidly with flashlight treatments and cooling also occurs at a much faster pace than within conventional thermal ovens.

The additional heating may be performed by any known method. In further embodiments, the semi-finished CdTe based thin film solar cell device is additionally heated to a temperature in the range of 100°C to 600°C.

In embodiments, the CdTe based absorber layer is formed in step b) as an absorber layer stack.

A CdTe based absorber layer stack means an absorber layer stack comprising a plurality of absorber layers, for instance different absorber layers like CdSe and CdTe layers. In further embodiments, the CdTe based absorber layer stack additionally comprises at least one doping layer.

In embodiments, the flashlight treatment is performed from a first interface of the CdTe based absorber layer oriented towards the substrate and/or from a second interface of the CdTe based absorber layer oriented away from the substrate. That is, the flashlight may be irradiated onto the absorber layer from any side of the semi-finished solar cell device with respect to its thickness direction. The thickness direction is that direction in which the substrate and the absorber layer lie above each other.

By choosing a specific side of the semi-finished solar cell device in correspondence with the materials of the substrate and the absorber layer, the wavelengths emitted by the light source and its irradiation intensity, the incoming photons will be absorbed in different positions and depth inside the material irradiated. Thus, the strength of the additional internal electric field may be adjusted.

For example, if the flashlight passes through the glass substrate and the initial material layers, it may be partially absorbed before arriving to the absorber region, useful to establish the electric field.

A first interface of the CdTe based absorber layer means the interface of the CdTe based absorber layer facing sunlight in a CdTe based thin film solar cell device in superstrate configuration or the interface of the CdTe based absorber layer not facing sunlight in a CdTe based thin film solar cell device in substrate configuration.

A second interface of the CdTe based absorber layer means the interface of the CdTe based absorber layer not facing sunlight in a CdTe based thin film solar cell device in superstrate configuration or the interface of the CdTe based absorber layer facing sunlight in a CdTe based thin film solar cell device in substrate configuration.

In embodiments, the flashlight treatment is performed by a flashlight source, wherein the flashlight source may comprise a plurality of flashlight sources. Each flashlight source emits flashlight with wavelengths in the range of 200 nm to 1000 nm, pulse intensities in the range of 0.1 mJ/cm² to 60 J/cm² and pulse durations in the range of 1 µs to 20 ms. The flashlight source may be arranged such that a first interface of the CdTe based absorber layer oriented towards the substrate and/or a second interface oriented away from the substrate is irradiated by the flashlight source.

In further embodiments, the light treatment is performed under vacuum, under atmospheric conditions or under controlled gas pressure conditions, such as for example in an oxygen atmosphere, an argon atmosphere, in the presence of chlorine, hydrogen or nitrogen or combinations of the above. The controlled atmospheres may also be at reduced pressure with respect to atmospheric pressures, such as 100 mbar (10⁴ Pa) or below. The controlled gas pressure conditions may also include the presence of dopants, such as vapours of e.g. As, Sb or P.

Vacuum means a pressure in the range of 10⁻⁷ mbar (10⁻⁵ Pa) to 10⁻¹ mbar (10 Pa) in the surrounding of the semi-finished solar cell.

Atmospheric conditions refers to normal air under normal pressure.

In other examples, the surrounding of the semi-finished solar cell may comprise hydrogen and may have a partial pressure in the range of 1 mbar (100 Pa) to 100 mbar (10⁴ Pa). The benefit of hydrogen presence in the atmosphere is that the oxidation state of, for instance, dopant species in the activated absorber layer can be changed, just as well as other oxidizing or reducing atmospheres can be applied to the same effect of changing oxidation states of species within the absorber.

For realization of the invention, it is advantageous to combine the described embodiments and features of the claims as described above. However, the embodiments of the invention described in the foregoing description are examples given by way of illustration and the invention is nowise limited thereto. Any modification, variation and equivalent arrangement should be considered as being included within the scope of the invention.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments dis-cussed herein. Therefore, it is intended that this invention is limited only by the claims and the equivalents thereof.

### Exemplary embodiments

The accompanying drawings are included to provide a further understanding of embodiments of the invention and are incorporated in and constitute a part of this specification. The drawings illustrate the embodiments of the present invention and together with the description serve to explain the principles. Other embodiments of the invention and many of the intended advantages will be readily appreciated, as they be-come better understood by reference to the following detailed description. The elements of the drawings are not necessarily to scale relative to each other. Like reference numbers designate corresponding similar parts.

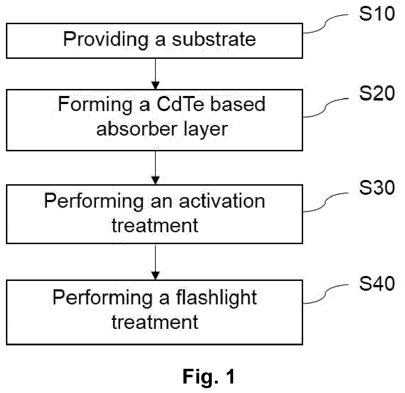

**Fig. 1** shows a schematic flow diagram of an exemplary embodiment of the method according to the invention.

**Fig. 1** shows the process flow of an embodiment of the method according to the invention. In a first step S10, a substrate is provided. In the following step S20, a CdTe based absorber layer is formed onto the provided substrate. An activation treatment according to state of the art is performed in step S30. Afterwards in step S40, a flashlight treatment is performed as multiple flashlight treatment comprising 5 pulses with a pulse duration of 1 ms and a pulse energy of 0.5 J/cm² each. The flashlight treatment in step S40 may be performed inside a process chamber under inert nitrogen conditions by a flashlight source, for instance a xenon flash lamp emitting flashlight with wavelengths in the range of 350 nm to 950 nm. The flashlight treatment is performed from a first interface of the CdTe based absorber layer oriented towards the substrate meaning that interface of the CdTe based absorber layer facing sunlight in a superstrate CdTe based thin film solar cell device after completing the semi-finished CdTe based thin film solar cell device by further processing steps known from state of the art.

According to the invention, the flashlight treatment in step S40 may be also performed before the activation treatment in step S30 or even during the activation treatment in step S30. In other embodiments, the flashlight treatment may be performed from a second surface of the CdTe based absorber layer meaning that interface of the CdTe based absorber layer not facing sunlight in a superstrate CdTe based thin film solar cell device after completing the semi-finished CdTe based thin film solar cell device by further processing steps known from state of the art.

## Claims

1. Method for manufacturing a semi-finished CdTe based thin film solar cell device at least comprising the following steps:
a) Providing a substrate,
b) Forming a CdTe based absorber layer,
c) Performing an activation treatment,
d) Performing a flashlight treatment,
wherein the flashlight treatment in step d) is performed before, after and/or during the activation treatment in step c).

2. Method according to claim 1, **characterized in that** the flashlight treatment is performed as a single or multiple flashlight treatment.

3. Method according to claim 1 or 2, **characterized in that** the flashlight treatment is performed with pulse durations in the range of 1 microsecond to 20 ms.

4. Method according to one of the claims 1 to 3, **characterized in that** the flashlight treatment is performed with pulse energies in the range of 0.1 mJ/cm² to 60 J/cm².

5. Method according to one of the claims 1 to 4, **characterized in that** the flashlight treatment is performed with wavelengths in the range for 250 nm to 1000 nm.

6. Method according to one of the claims 1 to 5, **characterized in that** the semi-finished CdTe based thin film solar cell device is additionally heated during the flashlight treatment in step d).

7. Method according to one of the claims 1 to 6, **characterized in that** the CdTe based absorber layer is formed in step b) as an absorber layer stack.

8. Method according to one of the claims 1 to 7, **characterized in that** the flashlight treatment is performed from a first interface of the CdTe based absorber layer oriented towards the substrate and/or from a second interface of the CdTe based absorber layer oriented away from the substrate.
